# EUROPEAN PATENT APPLICATION

(11) **EP 2 463 921 A1**
(43) Date of publication of application: **13.06.2012**
(21) Application number: 11192263.9
(22) Date of filing: 07.12.2011
(51) Int. Cl.: H01L 31/058

(54) **Photovoltaic and thermal panel**

(30) Priority: 10.12.2010 IT TO20100981
(71) Applicant: FEA S.r.l., 12030 Scarnafigi (Cuneo) (IT)
(72) Inventor: Fea, Antonio, I-12030 Scarnafigi (Cuneo) (IT)
(74) Representative: Gerbino, Angelo

(57) **Abstract**

The panel comprises: a box-shaped casing (10) formed by a bottom wall (12) and a side wall (14); a layer (16) of thermally insulating material arranged above the bottom wall (12); a first plate (18) which comprises cells (24) of photovoltaic material and acts as a cover of the box, whereby a hollow space (20) is defined between the first plate (18) and the layer (16); a second plate (28) of thermally conductive material which is arranged in the hollow space (20); and a circuit for the flow of a fluid, which is associated with the second plate (28).

## Description

The present invention relates to a panel for collecting solar radiation and converting it into forms of energy and/or energy carriers which can conveniently be exploited by the user.

EP-A-0 384 056 describes various embodiments of a solar panel comprising a cover formed by a transparent plate, separated by an air gap from a collector which is formed by a layer of photovoltaic cells and which is therefore independent of the cover and is positioned underneath the latter. Additionally, one embodiment of this panel includes a thermal absorber from which heat is extracted by means of conduits surrounded by an insulating material. From the description of this invention it cannot be concluded that these conduits form a circuit or that a heat transfer fluid other than air flows through them.

US-2007/0186922 describes various embodiments of a solar panel which does not have a box-shaped casing formed by a bottom wall and a side wall. This panel comprises multiwall layers which are provided with internal cavities in which a heat transfer fluid can flow, and which are made of polycarbonate namely a thermally non-conductive plastic material, as expressly disclosed in the text.

US-2004/025931 describes a combined solar panel which is formed by the juxtaposition of three superimposed components, namely a photovoltaic panel, a heat exchanger and a panel containing a heat transfer fluid, and which therefore does not have an outer casing with a cover incorporating the photovoltaic cells.

The object of the present invention is to provide a panel of the type indicated at the beginning of the present description, which is simple and economical as regards its construction and which can provide a high degree of versatility in its performance.

This object is achieved by means of a panel for collecting and converting solar radiation, comprising:
- a box-shaped casing formed by a bottom wall and a side wall,
- a layer of thermally insulating material arranged above the bottom wall,
- a first plate which comprises cells of photovoltaic material and is arranged as a cover of the box, whereby a hollow space is defined between the first plate and the layer of thermally insulating material,
- a second plate of thermally conductive material which is arranged in the hollow space, and
- a circuit for the flow of a fluid, which is associated with the second plate.

The panel according to the invention can collect solar radiation at two different levels, by using both the first and the second plate, which make use of electromagnetic radiation which covers a wide overall frequency range. More specifically, the first plate converts a fraction of the radiation spectrum to electrical energy, while the second plate is heated by a larger fraction of the radiation spectrum and then transfers the absorbed heat to the fluid flowing in the associated circuit. In particular, this fluid is water, which can be used directly in water heating systems and/or indirectly as a heat carrier for heating rooms or for other similar purposes.

Thus a single panel combines the functions of two panels, in other words a photovoltaic panel and a thermal panel, which are conventionally manufactured as independent products. This yields evident benefits in terms of space saving and cost reduction.

Furthermore, the absorption of heat by the second plate has the synergistic effect of reducing the temperature of the photovoltaic cells of the first plate by increasing the efficiency of the conversion of radiant energy to electrical energy, which rises as the temperature falls.

The presence of a casing formed by a bottom wall and a side wall imparts sufficient mechanical strength to the panel according to the invention. The incorporation of the photovoltaic cells into a plate which acts as the cover of the casing provides greater exposure to the sunlight and greater accessibility, enabling any maintenance work to be carried out more speedily. The association of the circuit for the flow of heat transfer fluid, particularly water, with a conducting plate makes the heat absorption more efficient. Furthermore, should any leaks occur, the fact that the circuit is associated with the plate but not incorporated into it, and is not fixed to the underlying thermally insulating layer, makes it possible to replace the circuit alone, either partially or completely, thus providing a considerable financial benefit.

Other advantages and characteristics of the present invention will become clear from the following detailed description which is given by way of non-limiting example with reference to the attached drawings, in which:

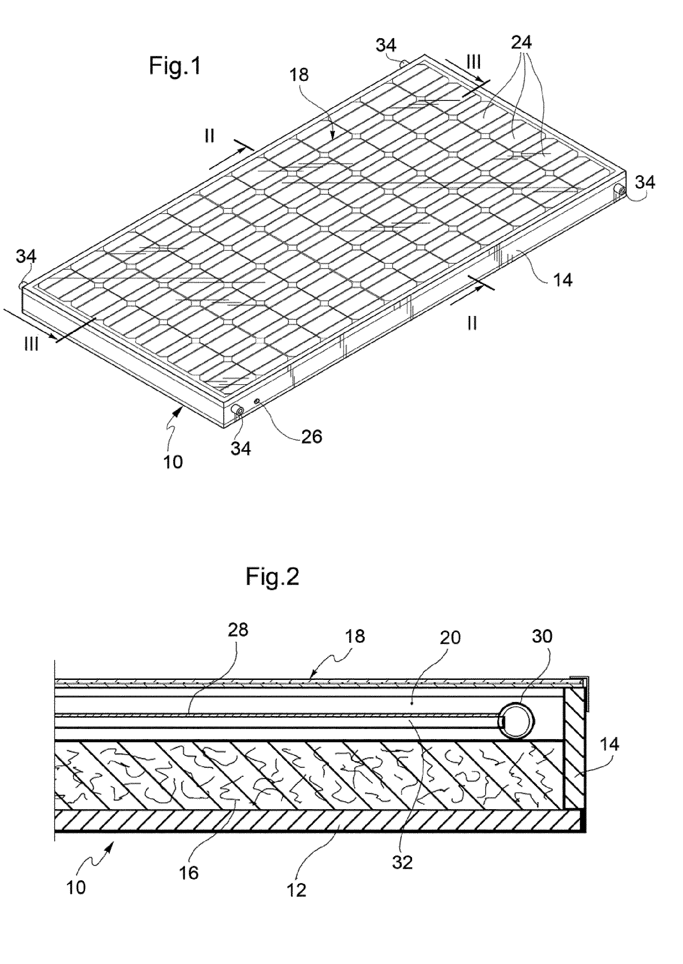

Figure 1 is a schematic perspective view of a panel according to the invention,
Figure 2 is a view in section along the line II-II of Figure 1,

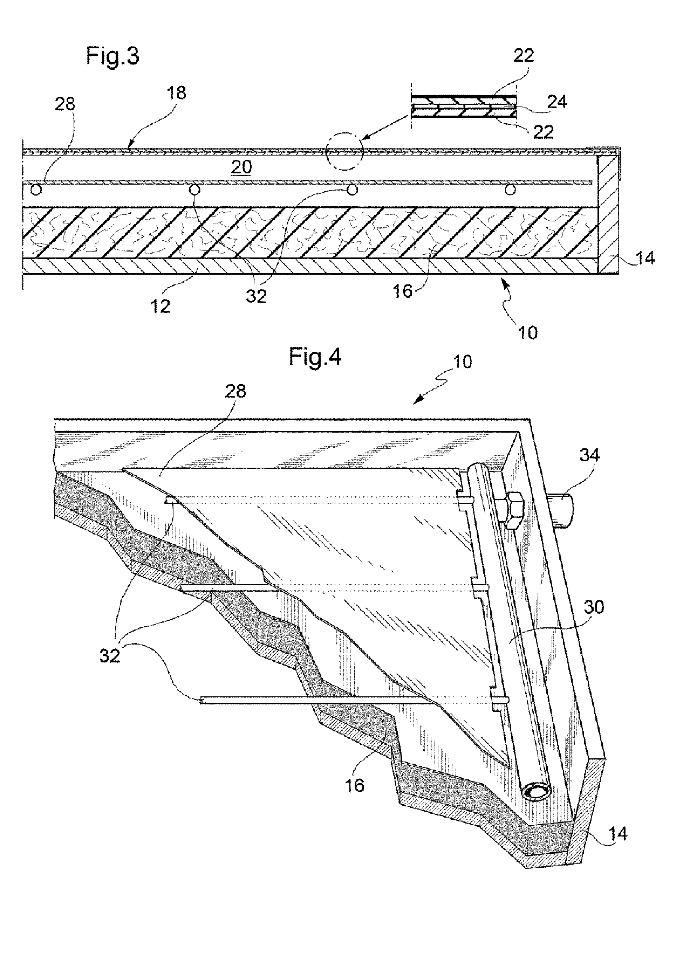

Figure 3 is a view in section along the line III-III of Figure 1, and
Figure 4 is a perspective view, on an enlarged scale and with parts removed, of a detail of the panel according to the invention.

A panel for collecting and converting solar radiation comprises a box-shaped casing 10 formed by a bottom wall 12 and a side wall 14, advantageously made of steel, particularly stainless steel. The panel is substantially rectangular in plan view with a perimeter formed by a pair of long sides and a pair of short sides. For guidance only, the dimensions of the panel could be 2000 mm x 1000 mm, with a thickness of approximately 100 mm.

A layer 16 of thermally insulating material, advantageously glass wool, is arranged over the bottom wall 12. Additionally, a first plate 18 is arranged in the form of a cover on the box 10, thereby defining a hollow space 20 between this plate and the layer 16 of thermally insulating material. The first plate 18 is formed by two parallel transparent sheets of glass 22 which enclose, in the form of a sandwich, a plurality of juxtaposed cells 24 of photovoltaic material. The cells 24 are electrically connected to connections 26 arranged outside the casing 10, enabling the electrical energy generated by the panel to be transported to the outside and/or to an adjacent panel.

A second plate 28 of thermally insulating material is arranged in the hollow space 20. Advantageously, this plate 28 is formed by a plurality of galvanically treated copper strips joined together.

The second plate 28 is associated with a circuit for the flow of a fluid, particularly water. The circuit is formed by a first and a second collector tube 30, each tube being adjacent to a respective long side of the panel, and by a series of secondary tubes 32 which connect the collector tubes 30 to each other and are substantially parallel to the short sides. The secondary tubes 32 are offset, and in particular are equally spaced, and are welded to the second plate 28. Sleeves 34 for plumbing connection to adjacent panels protrude outside the casing from the collector tubes 30.

In use, the panel described above has a dual function. In particular, the cells 24 of the first plate 18 can convert part of the solar radiation spectrum, particularly radiation with a wavelength of 100 to 1200 nm, to electrical energy. The underlying plate 28 can absorb radiation with a wavelength of 100 to 2600 nm which the plate 18 allows to pass, and the plate 28 is thus heated. The absorbed heat is then transferred to the water flowing in the circuit associated with the plate 28. In a known way, the water which has been heated in this way can be used directly in water heating systems and/or indirectly as a heat carrier for heating rooms or for other similar purposes.

Overall, the global radiant energy conversion efficiency of the panel according to the invention can reach values of 85%, as compared with values of 12% for a conventional photovoltaic panel.

Naturally, the principle of the invention remaining the same, the details of construction and the forms of embodiment may be varied widely with respect to those described, which have been given purely by way of example, without thereby departing from the scope of the invention as defined in the attached claims.

## Claims

1. Panel for collecting and converting solar radiation, comprising:
- a box-shaped casing (10) formed by a bottom wall (12) and a side wall (14),
- a layer (16) of thermally insulating material arranged above the bottom wall (12),
- a first plate (18) which comprises cells (24) of photovoltaic material and is arranged as a cover of the box, whereby a hollow space (20) is defined between the first plate (18) and the layer (16) of thermally insulating material,
- a second plate (28) of thermally conductive material which is arranged in the hollow space (20), and
- a circuit for the flow of a fluid, which is associated with the second plate (28).

2. Panel according to Claim 1, in which said casing (10) is of stainless steel.

3. Panel according to Claim 1 or 2, wherein said layer (16) of thermally insulating material is of glass wool.

4. Panel according to any one of the previous claims, wherein said first plate (18) is formed by two glass plates (22) which enclose said cells (24) of photovoltaic material.

5. Panel according to any one of the previous claims, wherein said second plate (28) is formed by a plurality of galvanically treated copper strips.

6. Panel according to any one of the previous claims, which is substantially rectangular in plan view with a perimeter formed by a pair of long sides and a pair of short sides.

7. Panel according to Claim 6, wherein said circuit is formed by a first and a second collector tube (30), each tube being adjacent to a respective long side of the panel, and by a series of secondary tubes (32) which connect said collector tubes (30) to each other and are substantially parallel to said short sides.

8. Panel according to Claim 7, wherein said secondary tubes (32) are welded to said second plate (28).

9. Panel according to Claim 7 or 8, wherein said secondary tubes (32) are offset and are preferably equally spaced.

10. Panel according to any one of Claims 7 to 9, wherein sleeves (34) for plumbing connection to adjacent panels protrude outside the casing (10) from the collector tubes (30).

11. Panel according to any one of the preceding claims, wherein said second plate (28) and the associated circuit are detached from the layer (16) of thermally insulating material.

12. Panel according to any one of the preceding claims, wherein said second plate (28) is capable of absorbing radiation with a wavelength in the range from 100 to 2600 nm, in such a way that the overall radiant energy conversion efficiency of the panel can be as much as 85%.

13. Panel according to any one of the preceding claims, wherein said fluid is water.
